Europäisches Patentamt

European Patent Office

Office européen des brevets

(19)

(11) Numéro de publication: **0 223 650 B1**

(12) **FASCICULE DE BREVET EUROPEEN**

(45) Date de publication de fascicule du brevet:
08.05.91

(21) Numéro de dépôt: 86402240.5

(22) Date de dépôt: 09.10.86

(51) Int. Cl.⁵: **H05K 9/00**

(54) **Joint d'étanchéité électromagnétique pour enceintes du type cage de faraday.**

(30) Priorité: **11.10.85 FR 8515113**

(43) Date de publication de la demande:
**27.05.87 Bulletin 87/22**

(45) Mention de la délivrance du brevet:
**08.05.91 Bulletin 91/19**

(84) Etats contractants désignés:
**DE GB**

(56) Documents cités:
**EP-A- 0 155 393**
**CH-A- 370 441**
**GB-A- 574 401**
**US-A- 2 727 084**

(73) Titulaire: **THOMSON-CSF**
**51, Esplanade du Général de Gaulle**
**F-92800 Puteaux(FR)**

(72) Inventeur: **Tailler, Louis**
**THOMSON-CSF SCPI 19, avenue de Messine**
**F-75008 Paris(FR)**
Inventeur: **Caniac, Raymond**
**THOMSON-CSF SCPI 19, avenue de Messine**
**F-75008 Paris(FR)**

(74) Mandataire: **Courtellemont, Alain et al**
**THOMSON-CSF SCPI**
**F-92045 PARIS LA DEFENSE CEDEX 67(FR)**

Rank Xerox (UK) Business Services

## Description

La présente invention se rapporte à un joint d'étanchéité électromagnétique pour enceintes du type cage de Faraday ; l'invention se rapporte plus particulièrement à un joint comportant une toile métallique et qui est destiné à assurer l'étanchéité électromagnétique entre les bords d'un orifice pratiqué dans une paroi et le panneau d'obturation de cet orifice, quand l'accès à travers cet orifice n'est que très exceptionnel (trappe de visite technique par exemple).

De tels joints sont connus qui comportent une toile métallique formée de fils de quelques dizièmes de millimètres de diamètre. Les joints connus peuvent se présenter sous la forme de boudins où la toile métallique forme une bande enroulée sur elle-même selon un axe parallèle aux côtés de la bande ; ils peuvent également se présenter sous la forme d'un boudin constitué d'un tube en toile métallique tricotée recouvrant un noyau en élastomère de silicone. Ces joints connus sont d'un prix de revient relativement élevé et, du fait qu'ils doivent être très fortement écrasés pour assurer une bonne étanchéité, ils sont très sérieusement déformés et doivent être changés après chaque ouverture du panneau.

La présente invention a pour but d'éviter ou, pour le moins, de réduire les inconvénients susmentionnés.

Ceci est obtenu en utilisant une bande métallique tissée et repliée sur elle-même.

Selon l'invention un joint d'étanchéité électromagnétique pour enceintes du type cage de Faraday, constitué d'une toile métallique, est caractérisé en ce que la toile métallique est constituée par une bande de largeur donnée, L, repliée n fois sur elle-même (n entier supérieur à zéro) selon n plis longitudinaux qui délimitent, dans la bande, n + 1 zones.

La présente invention sera mieux comprise et d'autres caractéristiques apparaîtront à l'aide de la description ci-après et des figures s'y rapportant qui représentent :

- les figures 1 et 2 des exemples de réalisation de joints selon l'invention et la façon de les raccorder à angle droit,
- la figure 3, un ensemble de quatre joints disposés selon les quatre côtés d'un rectangle,
- la figure 4, un tronçon de joint vu de dessus,
- la figure 5, une vue en coupe montrant un joint monté entre une paroi et un panneau.

Il est à noter que le brevet US-A-2 727 084 décrit des joints constitués d'une toile métallique et d'un manchon ; la toile est pliée longitudinalement puis arrangée sous forme d'un boudin à section cambrée, autour duquel est tricoté le manchon ;

l'ensemble, qui est élastique, est destiné à des portes à ouvertures relativement fréquentes.

Sur les différentes figures les éléments correspondants sont désignés par les mêmes repères.

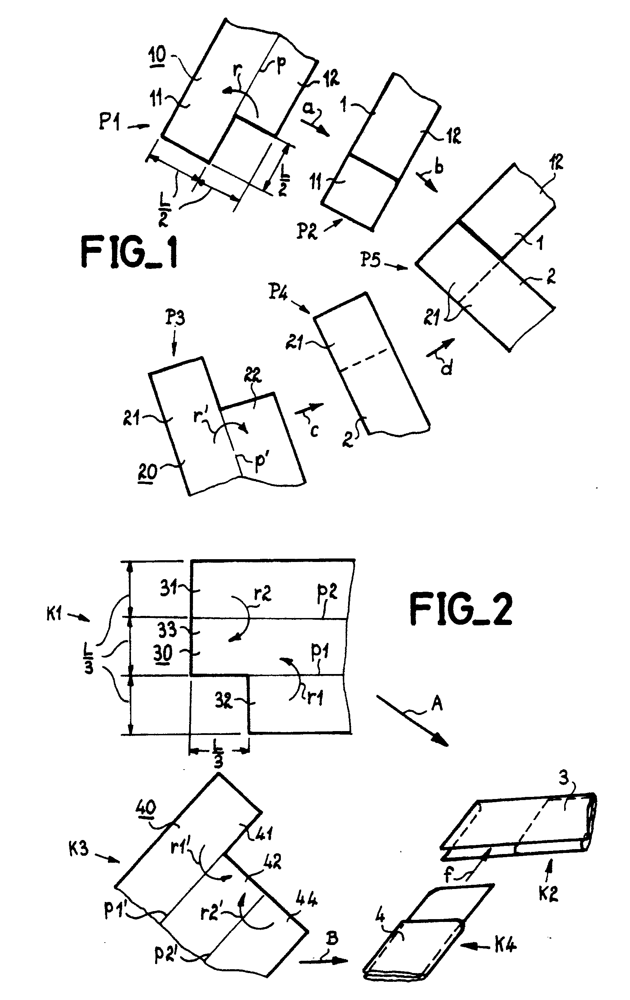

La figure 1 montre schématiquement, en cinq positions P1 à P5 différentes étapes qui, à partir de deux bandes, 10, 20, en toile métallique de largeur L, conduisent à l'obtention de deux joints, 1, 2, selon l'invention et à l'association de ces deux joints dans un raccordement à angle droit. Dans cette figure, comme d'ailleurs dans la figure 2, chaque bande n'a été représentée qu'au voisinage d'une de ses extrémités, l'extrémité non représentée étant du même type que l'une des extrémités représentées.

Sur la bande 10 représentée dans la position P1, une ligne symbolique, p, détermine deux zones, 11, 12, d'égales largeur $\frac{L}{2}$ , et une découpe carrée fait que l'extrémité de la zone 11 dépasse l'extrémité de la zone 12 d'une longueur $\frac{L}{2}$ .

Un pliage, par une rotation r autour de la ligne symbolique p, amène, comme l'indique une flèche a, à former un joint, 1, représenté en position P2.

Dans la position P3 est représentée une autre bande, 20, identique à la bande 10, avec ses deux zones 21, 22 de largeur $\frac{L}{2}$ et une ligne symbolique, p', autour de laquelle un pliage par une rotation, r', amène, comme l'indique une flèche C, à former un joint 2 représenté en position P4.

Les joints 1 et 2 sont amenés, comme indiqué par deux flèches, b et d, dans la position P5. Dans cette position les deux joints sont disposés à angle droit de telle manière que la partie de la zone 21, qui correspond au carré découpé au bout de la zone 22, se trouve dans le prolongement de la zone 12 et que, de même, la partie de la zone 11, qui correspond au carré découpé au bout de la zone 12, se trouve dans le prolongement de la zone 22 ; il est à noter que, dans la position P5, les zones 11 et 22 sont entièrement cachées par les zones 12 et 21. L'épaisseur du joint est constante sur toute sa surface.

La figure 2 montre schématiquement, en quatre positions K1 à K4, comment sont réalisés et assemblés à angle droit, deux joints 3, 4. Alors que les joints 1 et 2 de la figure 1 étaient des joints réalisés, chacun, par un seul pliage, les joints 3, 4 sont réalisés par deux pliages successifs.

Dans la position K1 est représentée une bande 30, en toile métallique, de largeur L, divisée par deux lignes symboliques p1 et p2, en trois zones 31, 33 et 32, sensiblement de même largeur $\frac{L}{3}$ . Une découpe carrée fait que les extrémités des zones jointives 31, 33, dépassent l'extrémité de la zone 32 d'une longueur $\frac{L}{3}$ . Deux pliages successifs, dont le premier par une rotation r1 (voir flèche) autour de la ligne symbolique p1, et le second par une rotation r2 (voir flèche) autour de la ligne symbolique p2, permettent d'obtenir (flèche A) le joint 3, représenté à la position K2.

Dans la position K2 est représentée une bande 40, en toile métallique, qui est légèrement différente de celle représentée dans la position K1 ; cette bande, également de largeur L, est séparée comme la bande 30 en trois zones 41, 42, 44, sensiblement de même largeur $\frac{L}{3}$ par deux lignes symboliques p1' et p2' mais ici, une découpe rectangulaire fait que les extrémités des zones jointives 42, 44 sont en retrait d'une longueur $\frac{L}{3}$ par rapport à l'extrémité de la zone 41. Deux pliages successifs, dont le premier par un rotation r1' (voir flèche) autour de la ligne symbolique p1' et le second par une rotation r2' (voir flèche) autour de la ligne symbolique p2', permettent d'obtenir (flèche B) le joint 4, représenté à la position K4.

Il est à noter que l'épaisseur des joints 3 et 4 représentés respectivement dans les positions K2 et K4 a été exagérée de manière à mieux montrer, en partie par transparence, comment ces joints ont été pliés.

Entre les joints 3 et 4 de la figure 2 une flèche f indique le sens de la translation à effectuer pour amener l'extrémité mâle du joint 4 dans l'extrémité femelle du joint 3 afin de réaliser une liaison à angle droit. A ce sujet il est à remarquer que les joints 1 et 2 de la figure 1, aussi bien que les joints 3 et 4 de la figure 2 permettent non seulement des liaisons à angle droit mais également des liaisons selon n'importe quel angle et, en particulier, des liaisons où les joints sont dans le prolongement l'un de l'autre ; simplement, pour faciliter la jonction, il pourra, dans certains cas, être utile d'adapter l'extrémité des joints, par exemple en réalisant une fente, sur une longueur $\frac{L}{3}$ et selon la ligne p2, dans la bande 30, à partir de l'extrémité de cette bande.

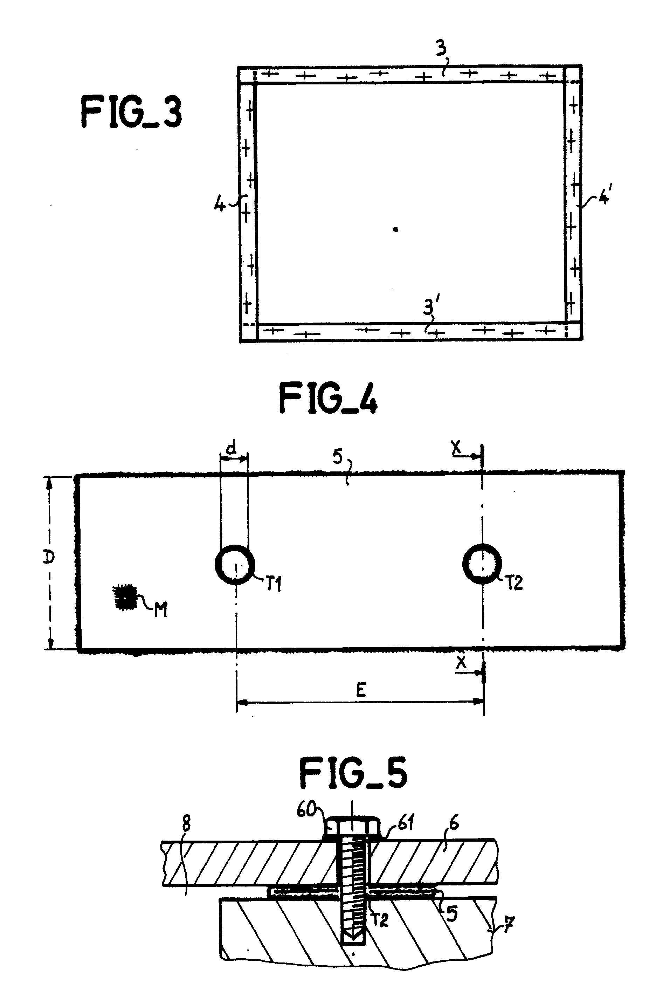

La figure 3 montre, de façon schématique, un assemblage en rectangle, réalisé à l'aide des deux joints 3 et 4 de la figure 2 et de deux joints 3' et 4' respectivement identiques aux joints 3 et 4 ; cet assemblage est destiné à assurer l'étanchéité électromagnétique entre les bords d'une ouverture rectangulaire et son panneau d'obturation. Comme il a été vu à l'aide de la figure 2 les extrémités par lesquelles les joints 3 et 4 sont assemblés sont respectivement femelle et mâle, par contre les extrémités des joints 3 et 4, qui n'étaient pas visibles sur la figure 2 sont respectivement mâle et femelle.

La figure 4 montre, vu de dessus, un joint 5, réalisé par deux pliages successifs comme dans la réalisation selon la figure 2. Ce joint, en toile métallique, a une largeur D de 45 mm ; son épaisseur est de 3 mm avant d'avoir servi et donc d'avoir été écrasé. Pour simplifier le dessin, seule une partie M de la trame métallique du tronçon de joint 5 a été représentée. Le joint de la figure 4 est en fait un tronçon d'un joint plus grand qui était percés de trous circulaires d'un diamètre d = 7 mm, répartis à une distance E = 45 mm les uns des autres selon l'axe longitudinal médian, non représenté, du joint ; deux de ces trous, T1 et T2, apparaissent sur la figure 4. Comme le montre la figure 5 les trous tels que T1 et T2 servent à la mise en place et à la fixation du joint.

La figure 5 est une vue en coupe montrant le joint 5 de la figure 4 disposé entre la paroi extérieure 7 d'une enceinte et un panneau 6 d'obturation d'une ouverture 8 pratiquée dans la paroi 7. La coupe selon la figure 5 correspond, pour le joint 5, à un plan de coupe perpendiculaire au plan de la figure 4 et de trace XX dans le plan de cette figure 4.

La figure 5 montre également une vis 60 avec sa rondelle 61; cette vis traverse successivement un trou lisse percé dans le panneau 6, le trou T2 percé dans le joint 5 et un trou fileté percé dans la paroi 7.

L'invention n'est pas limitée aux exemples décrits, elle s'applique d'une manière générale à des joints réalisés à partir d'une bande métallique repliée sur elle-même pour une succession de pliages ou au moins un pliage, comme dans le cas de la figure 1. Mais il n'est pas obligatoire que les zones comprises entre les plis soient sensiblement de même largeur pour rester dans le cadre de l'invention. De même, dans le cas où le nombre de pliages est supérieur à 1, les pliages successifs, au lieu de s'effectuer en spirale, comme dans le cas de la figure 2, peuvent s'effectuer en accordéon ou, même, en partie en spirale et en partie en accordéon.

**Revendications**

1. Joint d'étanchéité électromagnétique pour enceintes du type cage de Faraday, constitué d'une toile métallique, caractérisé en ce que la toile métallique est constituée par une bande de largeur donnée, L, repliée n fois sur elle-même (n entier supérieur à zéro) selon n plis longitudinaux qui délimitent, dans la bande, n + 1 zones.

2. Joint selon la revendication 1, caractérisé en ce que les n + 1 zones sont de largeur sensiblement égale à

$$\frac{L}{n+1}.$$

3. Joint selon la revendication 1, dans lequel n est supérieur à l, caractérisé en ce que, vu d'un extrémité de la bande, cette bande est repliée sur elle-même par au moins un pliage dans le sens direct et au moins un pliage dans le sens rétrograde.

4. Joint selon la revendication 1, caractérisé en ce que, à une au moins des extrémités du joint, m zones (m : entier positif au plus égal à n) dépassent, dans le sens longitudinal de la bande, les n-m autres zones d'une longueur sensiblement égale à

$$\frac{L}{n+1}.$$

5. Joint selon la revendication 4 dans lequel n = 2, caractérisé en ce que, pour une des deux extrémités du joint, m = 1 et la zone, qui dépasse, a ses deux faces respectivement en contact avec les deux autres zones et en ce que, pour l'autre extrémité, m = 2 et les deux zones qui dépassent sont deux zones jointives de la bande.

6. Joint selon la revendication l, caractérisé en ce qu'il est percé de trous destinés à permettre le passage de moyens de fixation du joint.

## Claims

1. An electromagnetic seal for enclosures of the Faraday cage type, constituted by a metallic fabric, characterized in that the metallic fabric is constituted by a strip with a given width L folded back on itself n times (n being a whole number greater than zero) in n longitudinal folds, which delimit n + 1 zones in the strip.

2. The seal as claimed in claim 1, characterized in that the n + 1 zones have a width substantially equal to

$$\frac{L}{n+1}.$$

3. The seal as claimed in claim 1, wherein n is greater than unity, characterized in that, as seen from one end of the strip, the same is folded back on itself at one fold at least in the forward direction and at least one fold in the backward direction.

4. The seal as claimed in claim 1, characterized in that at one end at least of the seal, m zones (m being a positive whole number equal to at least n) jut out, in the longitudinal direction of the strip, past the n - m other zones having a length substantially equal to

$$\frac{L}{n+1}.$$

5. The seal as claimed in claim 4, wherein n = 2, characterized in that, for one of the two ends of the seal, m = 1 and the zone, which juts out, has its two surfaces respectively in contact with the two other zones and in that, for the other end, m = 2 and the two zones which jut out are zones integral with the strip.

6. The seal as claimed in claim 1, characterized in that it has holes through it adapted for the passage of means for the attachment of the seal.

## Ansprüche

1. Elektromagnetische Dichtung für Behälter vom Typ eines Faraday-Käfigs, die ein Metalldrahtgewebe aufweist, dadurch gekennzeichnet, daß das Metalldrahtgewebe ein Band mit gegebener Breite L umfaßt, das entlang n longitudinalen Falzen, die auf dem Band n + 1 Bereiche begrenzen, n mal um sich selbst (n ganzzahlig und größer als null) gefaltet ist.

2. Dichtung gemäß Anspruch 1, dadurch gekennzeichnet, daß die n + 1 Bereiche eine Breite besitzen, die im wesentlichen gleich L/(n + 1) ist.

3. Dichtung gemäß Anspruch 1, bei der n größer als 1 ist, dadurch gekennzeichnet, daß dieses Band von einem seiner Enden aus gesehen um wenigstens einen Falz nach vorne und um wenigstens einen Falz nach hinten um sich selbst gefaltet ist.

4. Dichtung gemäß Anspruch 1, dadurch gekennzeichnet, daß an wenigstens einem der Enden der Dichtung m Bereiche (m: positive ganze Zahl kleiner oder gleich n) in Längsrichtung des Bandes über die n - m anderen Bereiche in einer Länge überstehen, die im wesentlichen gleich L/(n + 1) ist.

5. Dichtung gemäß Anspruch 4, bei der n = 2 ist, dadurch gekennzeichnet, daß für eines der zwei Enden der Dichtung m = 1 ist und die zwei Seiten des überstehenden Bereichs jeweils mit den zwei anderen Bereichen in Kontakt sind und daß für das andere Ende m = 2 ist und die zwei überstehenden Bereiche die zwei Dichtungsbereiche des Bandes sind.

6. Dichtung gemäß Anspruch 1, dadurch gekennzeichnet, daß sie von Löchern durchsetzt ist, die dazu vorgesehen sind, das Durchschieben von Befestigungsmitteln für die Dichtung zu ermöglichen.

# FIG_1

# FIG_2

## FIG_3

## FIG_4

## FIG_5

7